# EUROPEAN PATENT SPECIFICATION

(11) **EP 1 044 522 B1**
(45) Date of publication and mention of the grant of the patent: **23.04.2003**
(21) Application number: 98961328.6
(22) Date of filing: 18.12.1998
(51) Int. Cl.: H04B 10/08, H01S 5/02, G02B 6/12, G02B 6/42

(54) **OPTICAL DEVICE FOR MONITORING MULTI-WAVELENGTH SIGNALS**
OPTISCHE VORRICHTUNG ZUR ÜBERWACHUNG VON WELLENLÄNGENMULTIPLEXSIGNALEN
DISPOSITIF OPTIQUE POUR CONTROLER DES SIGNAUX A LONGUEURS D'ONDE MULTIPLES

(30) Priority: 23.12.1997 GB 9727013
(43) Date of publication of application: 18.10.2000
(73) Proprietor: Bookham Technology PLC, Abingdon, Oxon OX14 4RY (GB)
(72) Inventor: ASGHARI, Mehdi, Freshbrook, Swindon SN5 8RN (GB)
(74) Representative: Unwin, Stephen Geoffrey
(86) International application number: PCT/GB98/03830
(87) International publication number: WO 99/034539

(56) References cited:
- EP-A- 0 575 750
- EP-A- 0 585 094
- EP-A- 0 762 672
- DE-A- 19 519 486
- US-A- 4 786 133

## Description

### TECHNICAL FIELD

This invention relates to an optical device for monitoring multi-wavelength signals and, more particularly, signals output from a diffraction grating, for example in an optical communication system.

### BACKGROUND ART

The ability to sample the optical signal in different parts of an optical communication system is very important. This is usually required to enable some measurement to be performed on the signal, for example of its power, wavelength, signal to noise ratio etc. The sampling process usually requires the incorporation of some form of a tap-off coupler structure. The coupling action however tends to degrade the quality of the transmitted signal by distorting its spectrum, shape, polarisation etc. This in turn adversely affects the performance of the overall system. This is made worse by the fact that, to maximise system power budget (i.e. minimise power loss), it is desirable to tap-off only a very small proportion of the signal. The practical realisation of small split-ratio tap-off couplers, however, is very difficult as they are typically very fabrication, wavelength or polarisation sensitive.

In a Wavelength Division Multiplexing (WDM) system, the situation is significantly more complicated. Individual wavelength channels, being carried in the same physical fibre channel, must be detected on an individual basis. This requires the sampling of all channels and thus their separation to enable individual measurements to be performed on each channel. The sampling, in this case, must be wavelength insensitive to enable relative measurements between the channels. Separation of the sampled signals into the associated wavelength channels is difficult and requires "demultiplexer" functionality, which tends to be expensive.

If the sampling is performed within the demultiplexer stage in the system, significant advantage is achieved as the requirement for a separate demultiplexer is eliminated. However, sampling individual wavelengths from the individual output channels of the demultiplexer is not straightforward. The incorporation of a sampling coupler per output channel significantly increases the physical separation required between individual output ports which usually results in increased device size and degradation of its performance. Also, since a separate coupler is used to sample each channel, it is very difficult to achieve a uniform or predictable sampled channel distribution to enable relative measurements.

The invention provides an improved method and apparatus for monitoring a signal which avoids or reduces these problems.

EP-A-0762672 discloses an optical signal monitoring device which taps off a fraction of a multi-wavelength signal passing through an optical fibre and transmits this to a demultiplexer and a photodetector array.

### DISCLOSURE OF INVENTION

According to a first aspect of the present invention, there is provided an optical device for monitoring multi-wavelength signals comprising a diffraction grating for dividing a multi-wavelength optical signal into a plurality of signals each of a single wavelength or narrow wavelength band, first receiving means positioned to receive one or more signals from an m^{th} diffraction order from the diffraction grating and second receiving means positioned to receive one or more signals from a higher or lower (m + p)^{th} diffraction order from the diffraction grating; and monitoring means connected to the second receiving means to determine properties of one or more signals from said higher or lower diffraction order and thereby monitor properties of one or more signals in the m^{th} diffraction order.

According to a further aspect of the invention, there is provided an integrated optical transceiver comprising: a laser cavity formed between first and second feedback elements; a diffraction grating within the laser cavity for determining a lasing wavelength of the laser cavity; and light receiving means, the diffraction grating being arranged to receive light of a selected wavelength, differing from the lasing wavelength, and to transmit light of the selected wavelength to the light receiving means; the diffraction grating also being arranged to diffract light at the said lasing wavelength in a higher or lower diffraction order than the diffraction order used within the laser cavity and comprising output monitoring means for receiving said light in the higher or lower diffraction order in order to monitor the power output of the light emitted from the laser cavity.

Other features of the invention will be apparent from the following description and from the subsidiary claims of the specification.

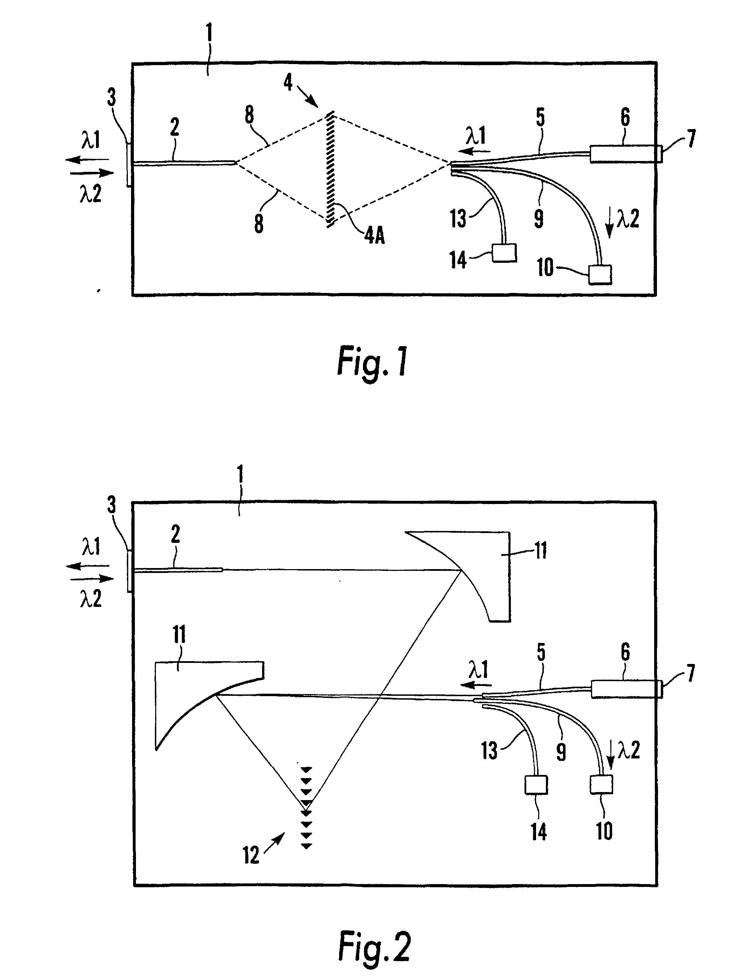

The term diffraction grating used herein is to be interpreted to include a reflection or transmission grating (e.g. as shown in Figures 1 to 3), an arrayed waveguide grating and other dispersive grating structures, including holographic or phase gratings.

### BRIEF DESCRIPTION OF DRAWINGS

The invention will now be further described, merely by way of example, with reference to the accompanying drawings, in which:
Figure 1 shows a schematic diagram of a first form of transceiver incorporating an optical device according to the invention;
Figure 2 shows a schematic diagram of a second form of transceiver incorporating an optical device according to the invention;
Figure 3 shows a schematic diagram of a WDM demultiplexer incorporating an optical device according to the invention;
Figure 4 illustrates the main and adjacent diffraction orders for a diffraction grating such as shown in Figures 1, 2 and 3; and
Figure 5 shows an enlarged view of the main channel spectrums from Figure 4.

Figures 1 and 2 show WDM transceivers incorporating an optical device according to the invention although it will be appreciated that the device may also be used in other applications. The subject matter of Figures 1 and 2 is also described and claimed in co-pending patent application GB9727013.6.

Figure 1 shows an optical chip 1, such as a silicon-on-insulator chip, on which the transceiver is formed. An integrated waveguide 2, such as a silicon rib waveguide, extends from a first feedback element 3, such as a polished, partly anti-reflective (AR) coating formed on a facet at one end of the waveguide 2 towards a transmission grating 4 formed by a series of narrow, shallow grooves 4A, etched in the surface of the silicon chip. A further waveguide 5 is formed on the chip 1 at a position to receive light at a selected angle from the transmission grating 4 and leads, via an optical amplifier 6, such as a semiconductor laser amplifier chip, to a second feedback element 7, such as a high reflection (HR) coated facet of the laser amplifier 6. In the example shown, the grating comprises a linear array of chirped period apertures so it also focuses the light transmitted therethrough.

Light travelling along the waveguide 2 towards the transmission grating 4 diverges into the silicon layer, as represented by the dashed lines 8 as it leaves the waveguide 2. Light leaves the transmission grating 4 in the form of an interference pattern generated by the linear array of chirped period apertures forming the grating in the well-known manner and comprises a series of peaks at different angular positions relative to the axis of the grating (i.e. an axis perpendicular to the grating and co-linear with the waveguide 2), each peak comprising light of a particular wavelength or wavelength band.

The waveguide 5 is positioned so as to receive light of a selected wavelength λ₁, which is to be the wavelength transmitted by the transceiver. Light of this wavelength is amplified in a laser cavity formed between the AR coating 3 and the HR coating 7 in a known manner and as the AR coating is only partially reflective, part of this light is transmitted from the transceiver through the AR coating 3 as the output of the transceiver at the wavelength λ₁.

Another waveguide 9 is also provided on the chip at a selected angle so as to receive light of a second wavelength λ₂ from the transmission grating 4 and transmit this light to a detector 10 such as a photodiode.

The spacing required between the waveguides 5 and 9 so they receive the respective wavelengths λ₁ and λ₂ would typically be in the order of 10 - 20 microns depending upon the dimensions and geometry of the arrangement.

The transmission grating thus acts to direct light of the second wavelength λ₂ received by the transceiver through the partly anti-reflective coating 3 to the photodiode 10.

The wavelength selective structure 4 is thus integrated as part of a laser cavity formed between the partly anti-reflection (AR) coated facet 3 and the high reflection (HR) coated facet 7 of the semi-conductor laser amplifier chip 6. The grating 4 is used to set the relative wavelengths of both the transmitted and received data inside the same chip. The grating 4 sets the transmitted wavelength of the laser by being part of the laser cavity and acting as a wavelength selective filter. At the same time, the grating 4 also acts as a bandpass filter ensuring that the detector 10 is illuminated by the correct range of wavelengths.

The wavelength selectivity of the grating 4, therefore, enables the formation of a closed cavity for laser oscillation at one wavelength λ₁ and the free detection of another wavelength λ₂ at the detector. The detector 10 is physically part of the laser resonator but is separated from it in the wavelength domain. The photodiode 10 terminating the waveguide 9 acts as a highly efficient absorber and prevents the formation of oscillations on that wavelength.

Figure 1 illustrates a first form of transceiver in which data on wavelength λ₂ is coupled into the device and is demultiplexed by the grating structure 4 to illuminate the detector 10. As indicated above, the example shown in Figure 1 incorporates a chirped focusing grating 4 to perform both demultiplexing and focusing.

Figure 2 shows a second form of transceiver which uses a combination of collimating and focusing mirrors 11 etched in the silicon chip together with a reflection grating 12. The mirrors 11 and reflection grating 12 can be formed by deep etches in the surface of the silicon chip.

The lasing wavelength of the laser is determined by the grating demultiplexer 12 by providing wavelength selective feedback at λ₁ in the optical amplifier 6.

The detected wavelength λ₂ received by the device is directed by the mirrors 11 and grating 4 to the detector 10. The grating 4 is thus again included in the laser cavity, multiplexing and demultiplexing the radiated lasing wavelength from that of the input data during each round trip cycle. This isolates the detector 9 and forms a laser cavity between the high reflection coated facet 7 of the laser, through the grating demultiplexer 12 to the partially anti-reflection coated facet 3 of the chip.

If the wavelengths λ₁ and λ₂ are significantly different, the anti-reflection coating 3 can be designed to have a lower value (i.e. be less reflective) for the detected wavelength λ₂ to improve coupling efficiency and a higher value (i.e. be more highly reflective) for the transmitted wavelength λ₁ to reduce the laser threshold.

The transceivers described above incorporate an optical device for monitoring the light emitted from the laser by sampling the light inside the laser cavity using the diffraction grating. The grating can be designed to carry a small but finite proportion of the laser power in a lower or higher diffraction order. This can be coupled to a further tap-off waveguide 13 and coupled to a further photodiode 14. By correct design, the spatial separation of this higher or lower diffraction order should be sufficiently different from that of the emitted and detected wavelengths λ₁ and λ₂ to allow well-spaced waveguides at the focal plane.

Figures 1 and 2 show a single tap-off waveguide 13, but additional tap-off waveguides may be provided to monitor each of the wavelengths of interest.

As indicated above, the transceiver described herein is preferably formed on a silicon-on-insulator (SOI) chip. An SOI chip enables easy integration of the various components of the transceiver and relatively low fabrication costs. Further details of SOI chips and rib waveguides formed thereon are given in WO95/08787

Methods of mounting components such as photodiode detectors on an SOI chip are described in GB2307786A and in co-pending application no. GB9702559.7 (publication no. GB2315595A).

The fabrication of transmission and reflection grating in the surface of an optical chip by electron beam or photolithographic techniques is well known so will not be described in detail. The transmission grating 4 would typically be formed of shallow grooves a fraction of a micron in depth (e.g. 0.2 microns) and width and a few microns in length. The period is chirped and would typically vary from a fraction of a micron to a few microns.

The reflection grating 12 would typically be formed of deep etched features with reflecting surfaces 5 - 20 microns wide, spaced about 5 - 20 microns apart and the grating may typically have a length of about 500 microns.

The mirrors 11 would also be formed by deep etches, extending all the way through the light guiding layer, and be from a few hundred microns to a few millimetres wide. The mirrors are preferably concave as shown in Fig. 2 so as to collimate and focus the light and may also have a reflective coating such as a coating of aluminium applied thereto. As indicated above, the grating and mirrors can be fabricated with great accuracy using known photolithographic etching processes, e.g. to within an accuracy of about 0.2 microns. Such accuracy is repeatable so enabling transceivers to be fabricated with accurately matched transmission and receiving wavelengths.

The above arrangement enables the sampling of individual wavelength channels within the demultiplexer used to demultiplex the channels without requiring a coupler per channel. The grating achieves the demultiplexing (multiplexing) action by spatially separating (dispersing) the individual wavelength channels into separate output waveguides.

In a conventional demultiplexer, the grating is designed to operate in a specific diffraction order dictated by device performance requirements, channel separation and centre channel wavelength and the grating is blazed to maximise the diffraction efficiency for this order. The grating is also usually designed to minimise the power content in all other diffraction orders.

The grating can, however, be designed to carry a small but finite proportion of the signal power in lower or higher diffraction orders, and in fact it almost always does. As described above, these can be used for monitoring purposes without affecting the properties of the main channels significantly. Dispersion properties, relative power, cross-talk, temperature dependence, channel response shape etc, of these orders are directly related to that of the main diffraction order, so measurements from the diffraction orders used for monitoring purposes can thus be easily linked to the main channel properties. The smaller proportion of power for each channel in such orders can also be focused into individual waveguides in a similar fashion to the main diffraction order. By correct design the spatial separation of this higher or lower diffraction order should be sufficiently different from that of the main channels to allow well-spaced waveguides at the focal plane.

The diffraction order used for monitoring does not need to be the adjacent order. Any higher or lower order can be used for this purpose. This order can be chosen and designed to have the required level of power content and channel uniformity. Some compromise, however, may be required on some aspects of the overall grating design to ensure the desired tap-off properties.

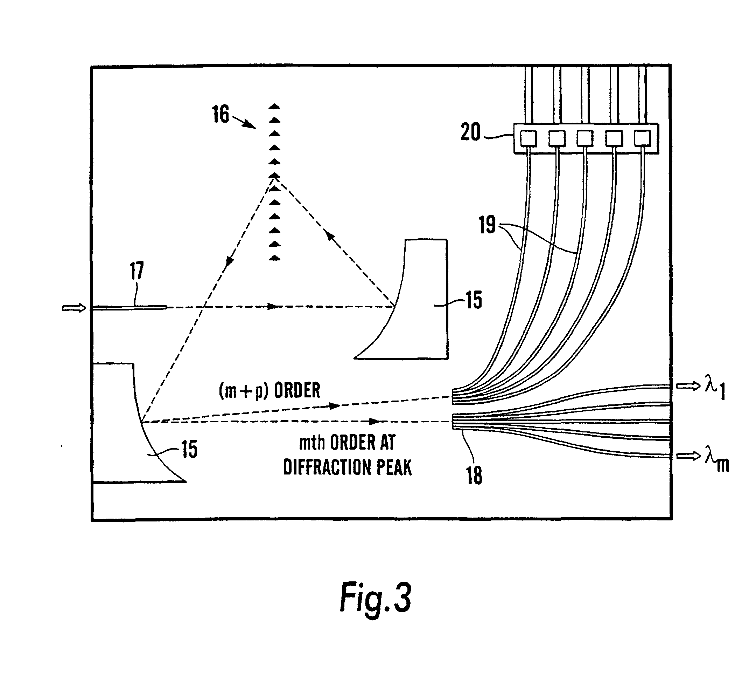

A further embodiment of the invention is illustrated in Figure 3. Figure 3 shows collimating and focusing mirrors 15 together with a reflection grating 16, arranged to demultiplex a signal received on an input waveguide 17.

A first diffraction order labelled the m^{th} order, is received by a first set of receiving waveguides 18 (for providing the output of the device) and another diffraction order, labelled the (m + p)^{th} order, is received by a second set of receiving waveguides 19, which lead to a bank of light detectors 20.

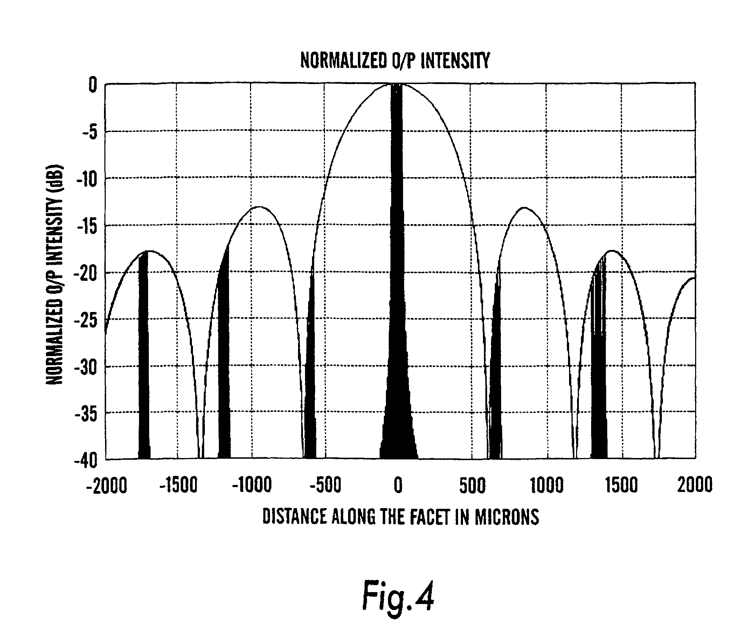

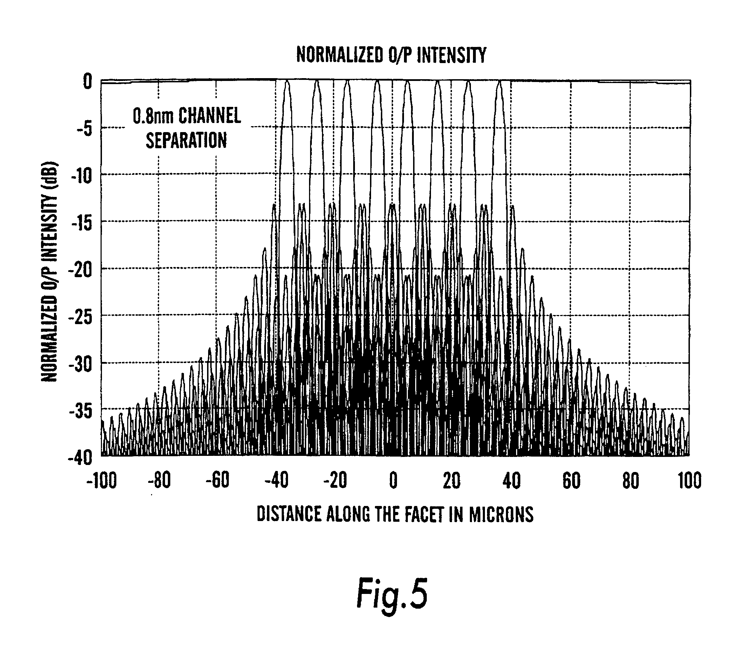

Figure 4 illustrates the main and adjacent diffraction orders for such a grating based demultiplexer. The grating used here has a pitch of 10 microns with 200 elements. A focal length of 10mm is used at both the input and the output mirrors 15. The demultiplexer is designed to operate with 8 channels, spaced 0.8nm apart from each other. The incidence angle on the grating 16 and mirror 15 in this example is 45° in all cases. The different wavelength signals are shown closely bunched in Figure 4 but the individual wavelengths are more clearly seen in Figure 5 described below.

As shown in Figure 4, the different diffraction orders provide different properties. Some provide more power, some increased dispersion and some better channel uniformity. Depending on the specific application, a design compromise will be required to achieve optimum sampling functionality. Typically, the sample power in a side order diffraction is 1 to 10% of the main order diffraction. This must be greater than the background noise of the demultiplexer.

Figure 5 shows an enlarged view of the main channel spectrum of Figure 4. The average spatial spacing between the modes is approximately 10 microns and the intensity variation across the channels (channel uniformity) is less than 1.5%.

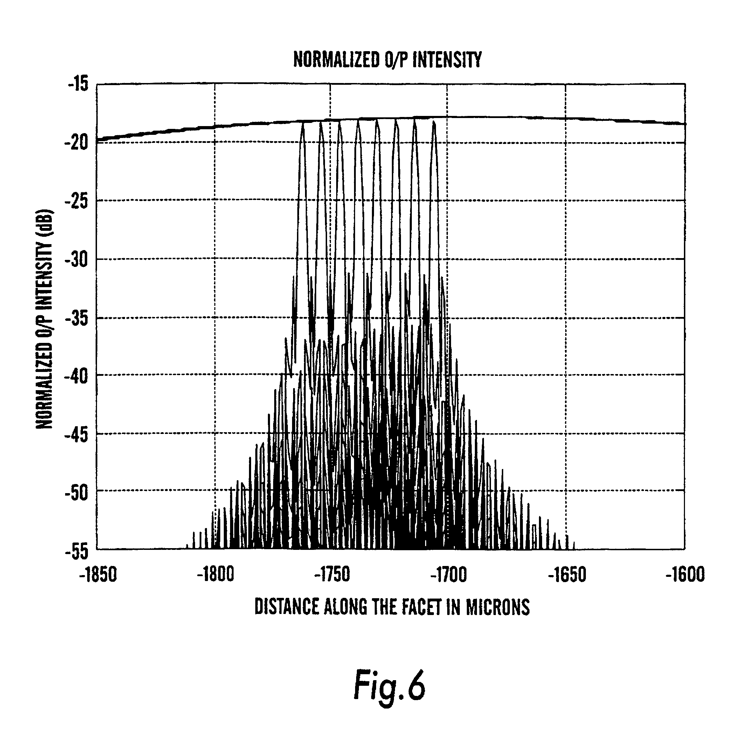

If the lowest third diffraction order (at -1700 microns) is chosen to provide monitoring, the channel distribution shown in Figure 6 would be achieved. As shown in this Figure, the monitor power for the centre channel in this case is approximately -18dB lower than the main channels. The average spatial spacing between the monitor channels is 8 microns and the channel uniformity is approximately 9% variation. Achieving such a small split ratio with little polarisation dependence would be very difficult with prior art devices, especially with such good channel uniformity. The non-uniformity can also be corrected as it is caused by the shape of the diffraction pattern for a single grating element and is thus well-known and should be repeatable. Furthermore, the monitor channels should show almost identical, thermal, polarisation, cross-talk etc. properties to the main channels.

The embodiment shown in Figure 3 uses a reflection grating but other forms of grating can be used.

The optical device described above thus has a number of advantages over the prior art:
- It has a simpler configuration and does not require any coupler elements.
- Monitoring is achieved automatically at the same time as the signal is demultiplexed.
- There is little or no polarisation, spectral and wavelength dependence or distortion in the tapping off mechanism.
- The device is relatively easy to manufacture and its performance is not affected by variations in its fabrication.
- The monitoring process has no, or little, effect on the channel uniformity or power of the main channel.
- In addition, monitor tap-offs do not have to be formed in between the waveguides carrying the main WDM channels.

The optical device described above can be used in any WDM system but, in particular, may be used in transceivers, such as those described, for use in a communication system.

## Claims

1. An optical device for monitoring multi-wavelength signals comprising a diffraction grating (4; 16) for dividing a multi-wavelength optical signal (8) into a plurality of signals (λ₁, λ₂ ...) each of a single wavelength or narrow wavelength band, first receiving means (5; 18) positioned to receive one or more signals from an m^{th} diffraction order from the diffraction grating (4: 16) and second receiving means (13; 19) positioned to receive one or more signals from a higher or lower (m + p)^{th} diffraction order from the diffraction grating (4: 16); and monitoring means (14; 20) connected to the second receiving means to determine properties of one or more signals from said higher or lower diffraction order and thereby monitor properties of one or more signals in the m^{th} diffraction order.

2. An optical device as claimed in Claim 1 in which the first receiving means is connected to an output of the device.

3. An optical device as claimed in Claim 1 or 2 in which the majority of the power of the multi-wavelength optical signal is output in the m^{th} diffraction order.

4. An optical device as claimed in Claim 3 in which 10% or less of the power of the multi-wavelength optical signal is output in the (m + p)^{th} diffraction order.

5. An optical device as claimed in any preceding claim in which the monitoring means comprises one or more light detectors.

6. An optical device as claimed in any preceding claim integrated on a chip.

7. An optical device as claimed in Claim 6 integrated on a silicon-on-insulator chip.

8. An optical device as claimed in Claim 6 or 7 in which the diffraction grating comprises a series of recesses formed in the surface of the chip.

9. An optical device as claimed in Claim 6, 7 or 8 in which the first and second receiving means each comprises one or more waveguides integrated on the chip.

10. An optical device as claimed in any preceding claim which forms part of a transceiver.

11. An integrated optical transceiver comprising: a laser cavity formed between first and second feedback elements (3, 7); a diffraction grating (4; 12) within the laser cavity for determining a lasing wavelength (λ₁) of the laser cavity; and light receiving means (9, 10), the diffraction grating being arranged to receive light of a selected wavelength (λ₂), differing from the lasing wavelength, and to transmit light of the selected wavelength to the light receiving means wherein the diffraction grating is also arranged to diffract light at the said lasing wavelength in a higher or lower diffraction order than the diffraction order used within the laser cavity and the transceiver further comprises output monitoring means (13, 14) for receiving said light in the higher or lower diffraction order in order to monitor the power output of the light emitted from the laser cavity.

## Patentansprüche

1. Optisches Gerät zum Überwachen von Mehrwellenlängen-Signalen, umfassend ein Beugungsgitter (4; 16) zum Aufteilen eines Mehrwellenlängen-Lichtsignals (8) in eine Mehrzahl von Signalen (λ₁, λ₂ ...), jeweils mit einer Wellenlänge oder einem schmalen Wellenlängenband, ein erstes Empfangsmittel (5; 18), das so positioniert ist, dass es ein oder mehrere Signale von einer m-ten Beugungsordnung von dem Beugungsgitter (4; 16) empfängt, und ein zweites Empfangsmittel (13; 19), das so positioniert ist, dass es ein oder mehrere Signale von einer höheren oder niedrigeren (m + p)-ten Beugungsordnung von dem Beugungsgitter (4; 16) empfängt, und ein Überwachungsmittel (14; 20), das mit dem zweiten Empfangsmittel verbunden ist, um Eigenschaften von einem oder mehreren Signalen von der genannten höheren oder niedrigeren Beugungsordnung zu bestimmen und dadurch Eigenschaften von einem oder mehreren Signalen in der m-ten Beugungsordnung zu überwachen.

2. Optisches Gerät nach Anspruch 1, bei dem das erste Empfangsmittel mit einem Ausgang des Gerätes verbunden ist.

3. Optisches Gerät nach Anspruch 1 oder 2, bei dem der größte Teil der Leistung des Mehrwellenlängen-Lichtsignals in der m-ten Beugungsordnung ausgegeben wird.

4. Optisches Gerät nach Anspruch 3, bei dem 10 % oder weniger der Leistung des Mehrwellenlängen-Lichtsignals in der (m + p)-ten Beugungsordnung ausgegeben wird.

5. Optisches Gerät nach einem der vorherigen Ansprüche, bei dem das Überwachungsmittel ein oder mehrere Lichtdetektoren umfasst.

6. Optisches Gerät nach einem der vorherigen Ansprüche, das auf einem Chip integriert ist.

7. Optisches Gerät nach Anspruch 6, das auf einem Siliciumauf-Isolator-Chip integriert ist.

8. Optisches Gerät nach Anspruch 6 oder 7, bei dem das Beugungsgitter eine Reihe von in der Oberfläche des Chips ausgebildeten Aussparungen aufweist.

9. Optisches Gerät nach Anspruch 6, 7 oder 8, bei dem das erste und das zweite Empfangsmittel jeweils ein oder mehrere auf dem Chip integrierte Hohlleiter umfassen.

10. Optisches Gerät nach einem der vorherigen Ansprüche, das Teil eines Transceivers bildet.

11. Integrierter optischer Transceiver, der Folgendes umfasst: einen Laserhohlraum, der zwischen einem ersten und einem zweiten Feedback-Element (3, 7) ausgebildet ist; ein Beugungsgitter (4; 12) in dem Laserhohlraum, um eine Laserwellenlänge (λ₁) des Laserhohlraums zu bestimmen; und ein Lichtempfangsmittel (9, 10), wobei das Beugungsgitter die Aufgabe hat, Licht einer ausgewählten Wellenlänge (λ₂) zu empfangen, die sich von der Laserwellenlänge unterscheidet, und Licht der ausgewählten Wellenlänge zu dem Lichtempfangsmittel zu senden, wobei das Beugungsgitter auch die Aufgabe hat, Licht mit der genannten Laserwellenlänge in einer höheren oder niedrigeren Beugungsordnung als die Beugungsordnung zu brechen, die in dem Laserhohlraum verwendet wird, und wobei der Transceiver ferner ein Ausgangsüberwachungsmittel (13, 14) umfasst, um das genannte Licht in der höheren oder niedrigeren Beugungsordnung zu empfangen, um den Leistungsausgang des von dem Laserhohlraum emittierten Lichtes zu überwachen.

## Revendications

1. Dispositif optique pour contrôler les signaux à longueurs d'onde multiples comprenant un réseau de diffraction (4 ; 16) pour diviser un signal optique à longueurs d'onde multiples (8) en une pluralité de signaux (λ₁, λ₂ ...) ayant chacun une seule longueur d'onde ou une bande de longueur d'onde étroite, un premier moyen de réception (5 ; 18) positionné pour recevoir un ou plusieurs signaux d'un m^{ième} ordre de diffraction du réseau de diffraction (4 ; 16) et un deuxième moyen de réception (13 ; 19) positionné pour recevoir un ou plusieurs signaux d'un (m + p)^{ième} ordre de diffraction supérieur ou inférieur du réseau de diffraction (4 ; 16) ; et un moyen de contrôle (14 ; 20) connecté au deuxième moyen de réception pour déterminer les propriétés d'un ou plusieurs signaux dudit ordre de diffraction supérieur ou inférieur et contrôler ainsi les propriétés d'un ou plusieurs signaux dans le m^{ième} ordre de diffraction.

2. Dispositif optique selon la Revendication 1 dans lequel le premier moyen de réception est connecté à une sortie du dispositif.

3. Dispositif optique selon la Revendication 1 ou 2, dans lequel la majorité de la puissance du signal optique à longueurs d'onde multiples sort dans le m^{ième} ordre de diffraction.

4. Dispositif optique selon la Revendication 3, dans lequel 10% ou moins de la puissance du signal optique à longueurs d'onde multiples sort dans le (m + p)^{ième} ordre de diffraction.

5. Dispositif optique selon l'une quelconque des revendications précédentes, dans lequel le moyen de contrôle comprend un ou plusieurs détecteurs de lumière.

6. Dispositif optique selon l'une quelconque des revendications précédentés, intégré sur une puce.

7. Dispositif optique selon la Revendication 6 intégré sur une puce de silicium sur isolant.

8. Dispositif optique selon la Revendication 6 ou 7, dans lequel le réseau de diffraction comprend une série de creux formés dans la surface de la puce.

9. Dispositif optique selon la Revendication 6, 7 ou 8, dans lequel les premier et deuxième moyens de réception comprennent chacun un ou plusieurs guides d'ondes intégrés sur is puce.

10. Dispositif optique selon l'une quelconque des revendications précédentes, qui fait partie d'un émetteur-récepteur.

11. Emetteur-récepteur optique intégré comprenant : une cavité laser formée entre des premier et deuxième éléments de réaction (3, 7) ; un réseau de diffraction (4 ; 12) à l'intérieur de la cavité laser pour déterminer une longueur d'onde laser (λ₁) de la cavité laser ; et un moyen récepteur de lumière (9, 10), le réseau de diffraction étant agencé pour recevoir la lumière d'une longueur d'onde sélectionnée (λ₂), différente de la longueur d'onde laser, et pour transmettre la lumière de la longueur d'onde sélectionnée au moyen récepteur de lumière, dans lequel le réseau de diffraction est aussi agencé pour diffracter la lumière à ladite longueur d'onde laser dans un ordre de diffraction plus élevé ou plus bas que l'ordre de diffraction utilisé dans la cavité laser et dans lequel l'émetteur récepteur comprend en outre des moyens de contrôle de sortie (13, 14) pour recevoir ladite lumière dans l'ordre de diffraction plus élevé ou plus bas afin de contrôler la puissance de sortie de la lumière émise de la cavité laser.
